# EUROPÄISCHE PATENTSCHRIFT

(11) **EP 2 409 189 B1**
(45) Veröffentlichungstag und Bekanntmachung des Hinweises auf die Patenterteilung: **14.08.2019**
(21) Anmeldenummer: 10706902.3
(22) Anmeldetag: 21.01.2010
(51) Int. Cl.: G02B 6/42, H05K 1/02, H05K 3/34

(54) **ANORDNUNG MIT EINEM ELEKTRISCHEN LEITERBAHNTRÄGER UND EINEM OPTOELEKTRONISCHEN BAUELEMENT SOWIE VERFAHREN ZUM HERSTELLEN EINER SOLCHEN ANORDNUNG**
ASSEMBLY COMPRISING AN ELECTRIC CONDUCTIVE TRACK CARRIER AND AN OPTOELECTRONIC COMPONENT AND METHOD FOR PRODUCING SUCH AN ASSEMBLY
ENSEMBLE COMPRENANT UN SUPPORT DE PISTE CONDUCTRICE ÉLECTRIQUE ET UN COMPOSANT OPTOÉLECTRONIQUE AINSI QUE PROCÉDÉ POUR FABRIQUER UN TEL ENSEMBLE

(30) Priorität: 18.03.2009 DE 102009013866
(43) Veröffentlichungstag der Anmeldung: 25.01.2012
(73) Patentinhaber: u2t Photonics AG, 10553 Berlin (DE)
(72) Erfinder: MATISS, Andreas, 10713 Berlin (DE); JACOB, Alexander, 12101 Berlin (DE); LEONHARDT, Christoph, 10439 Berlin (DE)
(74) Vertreter: Fischer, Uwe
(86) Internationale Anmeldenummer: PCT/DE2010/000079
(87) Internationale Veröffentlichungsnummer: WO 2010/105588

(56) Entgegenhaltungen:
- EP-A1- 1 885 026
- WO-A1-00/73831
- US-A1- 2003 059 177
- US-B1- 6 377 742

## Beschreibung

Die Erfindung bezieht sich auf eine Anordnung mit einem elektrischen Leiterbahnträger und einem auf dem Leiterbahnträger aufgebrachten Bauelement.

Im Bereich der Leiterplattentechnik sind u. a. elektrische Schnittstellen bekannt, die durch sogenannte BGAs (Ball Grid Arrays = Kugelgitteranordnungen) gebildet werden. Bei diesen Schnittstellen werden unterhalb des Bauelements matrixartig angeordnete Lotkügelchen bzw. Lotperlen mit dem Leiterbahnträger verlötet. Das Verlöten findet in einem Reflow-Ofen statt .

Zum Aufbringen von faseroptoelektronischen Bauelementen, die elektrooptische oder optoelektronische Komponenten und faseroptische Schnittstellen aufweisen, sind Lötprozesse in einem Reflow-Ofen nicht, zumindest nur eingeschränkt, einsetzbar, da nämlich die faseroptischen Schnittstellen sehr hitzeempfindlich sind und den während des Reflow-Lötens auftretenden thermischen Belastungen meist nicht standhalten. Dies liegt daran, dass faseroptische Schnittstellen in der Regel Kunststoffe aufweisen, die bei der Löttemperatur schmelzen oder sonst wie beschädigt werden. Faseroptoelektronische Bauelemente mit faseroptischen Schnittstellen lassen sich daher mit BGA-Schnittstellen bzw. mit Reflow-Lötprozessen in Reflow-Öfen in der Regel nicht auf Leiterplatten auflöten.

Darüber hinaus ist es bekannt, Bauelemente mit seitlich aus dem Gehäuse herausgeführten elektrischen Lötanschlusselementen auf Leiterbahnträgern in sogenannter SMD-Technik (SMD: surface-mounted device = oberflächenmontierbares Bauteil) aufzulöten. Problematisch ist jedoch, dass solche Schnittstellen aufgrund unterschiedlicher thermischer Ausdehnung der Materialien die Lötverbindungen relativ großem mechanischem Stress ausgesetzt werden, insbesondere bei großen Gehäusen, so dass es zu Schäden an der elektrischen Schnittstelle kommen kann. Im Übrigen ist es nicht ohne weiteres möglich, über die bekannten SMD-Schnittstellen hohe Signalfrequenzen von 20 GHz oder mehr zu übertragen. Die bekannte SMD-Schnittstellentechnik ist somit für das Auflöten faseroptoelektronischer Bauelemente auf Leiterbahnträgern ebenfalls nicht sonderlich geeignet.

Eine Anordnung mit den Merkmalen gemäß dem Oberbegriff des Patentanspruchs 1 und ein Verfahren mit den Merkmalen gemäß dem Oberbegriff des Patentanspruchs 14 sind aus der europäischen Patentanmeldung EP 1 885 026 A1 bekannt.

Weitere Anordnungen werden in den Schriften US 2003/0059177 A1, US 6,377,742 B1 und WO 00/73831 A1 beschrieben.
Der Erfindung liegt die Aufgabe zugrunde, eine Anordnung mit einem elektrischen Leiterbahnträger und einem auf dem Leiterbahnträger aufgebrachten faseroptoelektronischen Bauelement anzugeben, die für Signalfrequenzen von 20 GHz oder mehr geeignet ist und sich einfach und kostengünstig herstellen lässt.

Diese Aufgabe wird erfindungsgemäß durch eine Anordnung mit den Merkmalen gemäß Patentanspruch 1 gelöst; vorteilhafte Ausgestaltungen der Erfindung sind in Unteransprüchen angegeben.

Ein wesentlicher Vorteil der erfindungsgemäßen Anordnung ist darin zu sehen, dass diese sehr hohe elektrische Betriebs- bzw. Signalfrequenzen ermöglicht, wie sie im Bereich der optischen Datenübertragung eingesetzt werden. Dies ist auf die gebogenen Lötanschlusselemente zurückzuführen, die sich von unterhalb des Gehäuses seitlich aus der äußeren Kontur des Gehäuses heraus erstrecken und seitlich neben dem Gehäuse auf dem Leiterbahnträger verlötet werden. Der gebogene Bereich des Lötanschlusselements reduziert Reflexionen, so dass die elektrische Schnittstelle für Signalfrequenzen von 20 GHz oder mehr geeignet ist, wie sie von Bauelementen der optischen Nachrichtentechnik verarbeitet werden können.

Ein weiterer wesentlicher Vorteil der erfindungsgemäßen Anordnung ist darin zu sehen, dass diese mechanische Spannungen im Bereich der elektrischen Schnittstelle vermeidet, da durch den erfindungsgemäß vorgesehenen Abstand zwischen dem Gehäuse und dem Leiterbahnträger im Bereich des Bodenanschlussabschnitts mechanisches Spiel geschaffen wird. Durch dieses Spiel werden mechanische Spannungen abgefangen, so dass die Lötstellen, die das andere Ende der Lötanschlusselemente mit dem Leiterbahnträger verbinden, mechanisch entlastet werden.

Um Reflexionen im Bereich der elektrischen Schnittstelle noch weiter zu reduzieren, ist erfindungsgemäß vorgesehen, dass in zumindest einem Teilabschnitt des Spalts zwischen dem Bodenanschlussabschnitt und dem Leiterbahnträger eine Wellenwiderstandsanpassung vorgesehen wird. Darüber hinaus ist vorgesehen, dass der Gehäuseboden einen Bodenauflageabschnitt aufweist, der auf dem Leiterbahnträger unmittelbar aufliegt, und das Gehäuse zumindest einen Befestigungsabschnitt aufweist, der mit dem Leiterbahnträger verschraubt ist.

Vorzugsweise wird der Spalt zwischen dem Bodenanschlussabschnitt und dem Leiterbahnträger zumindest teilweise mit einem Material gefüllt, dessen relative Dielektrizitätszahl größer als 1 ist. Beispielsweise ist auf dem Leiterbahnträger in dem Bereich des Spalts eine Beschichtung mit dem genannten Material aufgebracht. Vorzugsweise besteht die Beschichtung aus einem anderen Material als die Leiterbahnen des Leiterbahnträgers.

Gemäß einer besonders bevorzugten Ausgestaltung der Anordnung ist vorgesehen, dass der Befestigungsabschnitt ein Befestigungsloch aufweist, durch das sich eine Befestigungsschraube erstreckt, wobei der Durchmesser des Befestigungslochs größer als der Durchmesser der Befestigungsschraube dimensioniert ist, so dass ein mechanische Spannungen abbauendes Spiel zwischen Befestigungsloch und Befestigungsschraube vorhanden ist.

Die elektrische Schnittstelle umfasst bevorzugt mehrere gebogene elektrische Lötanschlusselemente, die eine oder mehrere koplanare elektrische Leitungen bilden. Beispielsweise handelt es sich um koplanare elektrische Leitungen, die mit differentiellen Signalen betrieben werden bzw. betrieben werden können.

Um mechanische Spannungen noch weiter zu reduzieren, eine bessere Wärmeabfuhr während des Lötens zu erreichen und die Lotverteilung zu verbessern, ist vorzugsweise zumindest ein gebogenes elektrisches Lötanschlusselement geschlitzt und bildet mindestens zwei nebeneinander liegende elektrische Einzelleiter. Vorzugsweise ist die Wärmekapazität aller ungeschlitzten Lötanschlusselemente untereinander gleich groß, und sie ist bevorzugt zumindest näherungsweise so groß wie die Wärmekapazität der Einzelleiter der geschlitzten Lötanschlusselemente.

Bevorzugt ist eine Gruppe von nebeneinanderliegenden gebogenen elektrischen Lötanschlusselementen elektrisch in der Reihenfolge Masse, Signal, Masse, Signal, Masse beschaltet, um Signale besonders störungsarm zu übertragen.

Das mittlere, auf Masse geschaltete Lötanschlusselement der Gruppe ist vorzugsweise geschlitzt und bildet jeweils zwei nebeneinanderliegende Einzelmasseleiter, so dass sich an der Schnittstelle zum Leiterbahnträger die elektrische Beschaltungskonfiguration Masse, Signal, Masse, Masse, Signal, Masse ergibt.

Die Dicke der als Masseleiter beschalteten Lötanschlusselemente und die Dicke der als Signalleiter beschalteten Lötanschlusselemente sind vorzugsweise gleich groß.

Das Verhältnis zwischen der Breite eines ungeschlitzten Masseleiters und der Breite eines Signalleiters ist vorzugsweise kleiner als oder gleich zwei.

Das Verhältnis zwischen der Breite eines Einzelmasseleiters eines geschlitzten, auf Massepotential liegenden Lötanschlusselements und der Breite eines Signalleiters ist vorzugsweise kleiner als oder gleich zwei.

Die Erfindung bezieht sich darüber hinaus auf ein Verfahren zum Herstellen einer Anordnung mit einem elektrischen Leiterbahnträger und einem Bauelement, wobei bei dem Verfahren das Bauelement auf dem Leiterbahnträger aufgelötet wird.

Erfindungsgemäß sind bezüglich dieses Verfahrens die Merkmale gemäß Patentanspruch 11 vorgesehen.

Bezüglich der Vorteile des erfindungsgemäßen Verfahrens sei auf die obigen Ausführungen im Zusammenhang mit der erfindungsgemäßen Anordnung verwiesen.

Vorzugsweise wird in zumindest einem Teilabschnitt des Spalts zwischen dem Bodenanschlussabschnitt und dem Leiterbahnträger eine Wellenwiderstandsanpassung vorgenommen.

Die Erfindung wird nachfolgend anhand von Ausführungsbeispielen näher erläutert; dabei zeigen beispielhaft:
- Figur 1: ein erstes Ausführungsbeispiel für eine erfindungsgemäße Anordnung mit einem elektrischen Leiterbahnträger und einem auf dem Leiterbahnträger befindlichen Bauelement, wobei eine Wellenwiderstandsanpassung durch eine Beschichtung gebildet ist,
- Figur 2: ein zweites Ausführungsbeispiel für eine erfindungsgemäße Anordnung mit einem Leiterbahnträger und einem darauf befindlichen Bauelement, wobei eine Wellenwiderstandsanpassung durch ein den Spalt zwischen Bauelement und Leiterbahnträger füllendes Material gebildet ist,
- Figur 3: die Anordnung gemäß Figur 1 oder 2 in der Draufsicht,
- Figur 4: ein Ausführungsbeispiel für ein geschlitztes Lötanschlusselement und
- Figur 5: ein Ausführungsbeispiel für eine erfindungsgemäße Anordnung in der Draufsicht mit einem geschlitzten Lötanschlusselement, das einen Masseleiter bildet.

In den Figuren werden der Übersicht halber für identische oder vergleichbare Komponenten stets dieselben Bezugszeichen verwendet.

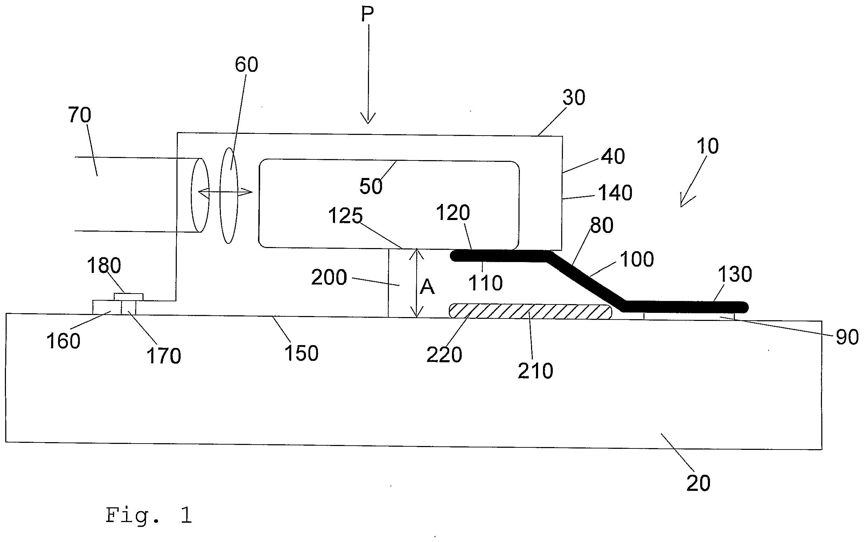

In der Figur 1 ist eine Anordnung 10 mit einem elektrischen Leiterbahnträger 20 dargestellt, auf dem ein faseroptoelektronisches Bauelement 30 befestigt ist. Das faseroptoelektronische Bauelement 30 weist ein Gehäuse 40 auf, in dem eine elektrooptische oder optoelektronische Komponente 50 integriert ist.

Die elektrooptische oder optoelektronische Komponente 50 steht über eine faseroptische Schnittstelle 60, beispielsweise über eine Glasfaserschnittstelle, mit einem Lichtwellenleiter 70, beispielsweise einer Glasfaser, in Verbindung. Die optische Schnittstelle 60 ist in oder an dem Gehäuse 40 befestigt.

Über eine elektrische Schnittstelle 80 steht die Komponente 50 mit Leiterbahnen 90 des elektrischen Leiterbahnträgers 20 in Verbindung.

Die elektrische Schnittstelle 80 umfasst eine Vielzahl an gebogenen Lötanschlusselementen 100, die jeweils mit ihrem einen Ende 110 an einem Bodenanschlussabschnitt 120 des Gehäuses 40 bzw. des Gehäusebodens 125 angebracht sind; mit ihrem anderen Ende 130 sind die Lötanschlusselemente 100 auf den Leiterbahnen 90 aufgelötet.

In der Figur 1 lässt sich erkennen, dass die Lötanschlusselemente 100 vom Bodenanschlussabschnitt 120 nach unten weggebogen bzw. zu dem Leiterbahnträger 20 hingebogen sind, so dass der Bodenanschlussabschnitt 120 des Gehäuses 40 einen Abstand A von der Oberfläche des elektrischen Leiterbahnträgers 20 aufweist. Der Spalt 200 zwischen dem Bodenanschlussabschnitt 120 und dem elektrischen Leiterbahnträger 20 wird durch die gebogenen Lötanschlusselemente 100 überbrückt.

Darüber hinaus erkennt man in der Figur 1, dass sich die gebogenen Lötanschlusselemente 100 seitlich nach außen erstrecken und seitlich - in der Draufsicht bzw. von oben entlang der Pfeilrichtung P betrachtet - außerhalb der äußeren Gehäusekontur 140 des Gehäuses 40 auf dem Leiterbahnträger 20 verlötet sind. Mit anderen Worten befinden sich die Lötstellen, die das andere Ende 130 der gebogenen Lötanschlusselemente mit den Leiterbahnen 90 verbinden, nicht unterhalb des Gehäuses 40, sondern seitlich neben dem Gehäuse 40.

In der Figur 1 erkennt man darüber hinaus, dass das Gehäuse 40 einen Bodenauflageabschnitt 150 aufweist, der unmittelbar auf dem elektrischen Leiterbahnträger 20 aufliegt und mit diesem verbunden ist. Die Verbindung zwischen dem Gehäuse 40 und dem elektrischen Leiterbahnträger 20 erfolgt durch einen oder mehrere Befestigungsabschnitte 160 des Gehäuses 40, die ein Verschrauben auf dem Leiterbahnträger 20 ermöglichen. Hierzu sind die Befestigungsabschnitte 160 jeweils mit einem Befestigungsloch 170 ausgestattet, durch das eine Befestigungsschraube 180 hindurchgeführt ist. Die Befestigungsschraube 180 ist mit dem Leiterbahnträger 20 verschraubt. Vorzugsweise ist die Größe des Befestigungsloches 170 derart gewählt, dass das Gehäuse 40 auf dem elektrischen Leiterbahnträger 20 ein gewisses Spiel aufweist, so dass mechanische Spannungen nach einem Befestigen des Gehäuses 40 auf dem Leiterbahnträger 20 verhindert, zumindest reduziert, werden.

Um zu erreichen, dass das faseroptoelektronische Bauelement 30 mit sehr hohen Frequenzen bzw. mit hohen Bandbreiten betrieben werden kann, kann der Spalt 200 zwischen dem Bodenanschlussabschnitt 120 und dem Leiterbahnträger 20 bei dem Ausführungsbeispiel gemäß Figur 1 mit einer Wellenwiderstandsanpassung 210 ausgestattet sein. Die Wellenwiderstandsanpassung 210 beruht auf einer Beschichtung 220, die im Bereich unterhalb des Bodenanschlussabschnitts 120 auf dem Leiterbahnträger 20 aufgebracht ist. Die Funktion der Beschichtung 220 besteht darin zu verhindern, dass in dem gebogenen mittleren Abschnitt des Lötanschlusselements 100 der Leitungswellenwiderstand des Lötanschlusselements stark vom eigentlichen Wellenwiderstand der Koplanarleitung abweicht und Reflexionen auftreten. Mit anderen Worten soll die Beschichtung 220 sicherstellen, dass ein elektrisches Signal, das von dem einen Ende 110 zu dem anderen Ende 130 oder umgekehrt von dem anderen Ende 130 zu dem einen Ende 110 des Lötanschlusselements übertragen wird, keinen elektrischen Reflexionen unterworfen wird, die den zeitlichen Signalverlauf verfälschen würden.

Das Material der Beschichtung 220 ist vorzugsweise ein anderes Material als das Material der Leiterbahnen 90, die zu dem elektrischen Leiterbahnträger 20 gehören. Die relative Dielektrizitätszahl der Beschichtung 220 ist vorzugsweise größer als 1. Die Beschichtung 220 kann beispielsweise aus einem Polymer bestehen.

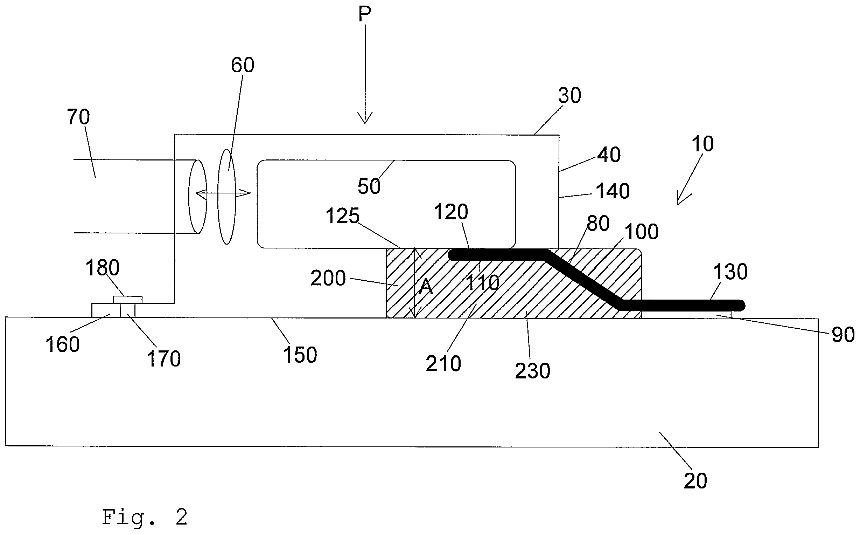

In der Figur 2 ist ein zweites Ausführungsbeispiel für eine Anordnung 10 mit einem faseroptoelektronischen Bauelement 30 und einem Leiterbahnträger 20 dargestellt. Es lässt sich erkennen, dass die Wellenwiderstandsanpassung 210 bei dem Ausführungsbeispiel gemäß Figur 1 nicht durch eine Beschichtung 220, sondern durch ein den Spalt 200 füllendes Material 230 gebildet ist, dessen relative Dielektrizitätszahl vorzugsweise größer als 1 ist. Das den Spalt 200 füllende Material 230 kann beispielsweise aus einem Polymer bestehen. Das Material 230 bildet somit ein Wellenwiderstandsanpassungsmaterial, das den Spalt 200 im Bereich der Lötanschlusselemente 100 bzw. zwischen dem Bodenanschlussabschnitt 120 und dem Leiterbahnträger 20 füllt.

Im Übrigen entspricht das Ausführungsbeispiel gemäß Figur 2 dem Ausführungsbeispiel gemäß Figur 1, so dass diesbezüglich auf die obigen Ausführungen verwiesen sei.

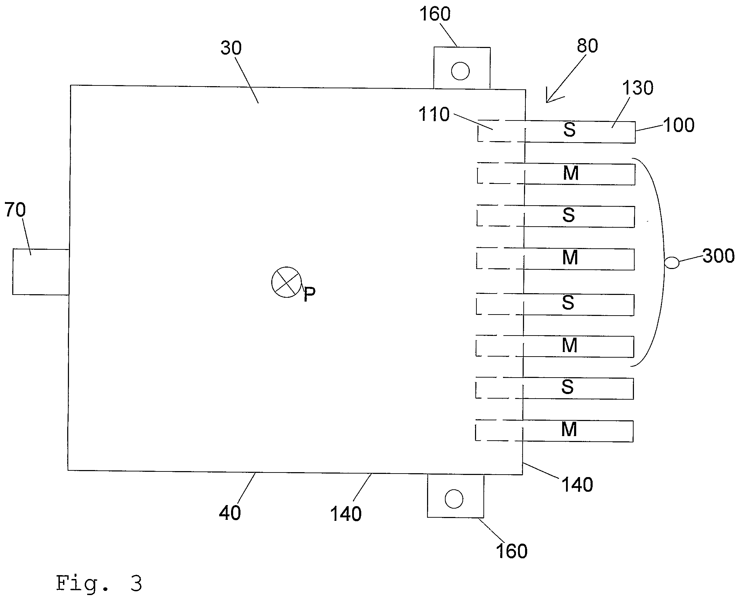

In der Figur 3 erkennt man die Anordnung 10 gemäß Figur 1 oder 2 in der Draufsicht (entlang der Pfeilrichtung P gesehen). Es lässt sich erkennen, dass die elektrische Schnittstelle 80 eine Vielzahl an gebogenen Lötanschlusselementen 100 aufweist, die sich seitlich vom Gehäuseboden kommend nach außen erstrecken, so dass die anderen Enden 130 der Lötanschlusselemente 100 außerhalb der äußeren Kontur 140 des Gehäuses 40 angeordnet sind. Der von dem Gehäuse verdeckte Abschnitt der Lötanschlusselemente 100 ist mit gestrichelten Linien gekennzeichnet. Auch ist in der Figur 3 der Lichtwellenleiter 70 dargestellt, der an die faseroptische Schnittstelle 60 (vgl. Figuren 2 und 3) angeschlossen ist.

Darüber hinaus lässt sich erkennen, dass die Lötanschlusselemente koplanare elektrische Leitungen bilden und abwechselnd als Masseleiter oder Signalleiter betrieben werden. In der Figur 3 sind Signalleiter mit dem Bezugszeichen S und Masseleiter mit dem Bezugszeichen M gekennzeichnet.

Auch lässt sich in der Figur 3 eine Gruppe 300 mit nebeneinanderliegenden gebogenen elektrischen Lötanschlusselementen erkennen, die elektrisch in der Reihenfolge Masse, Signal Masse, Signal, Masse beschaltet sind.

Die Figur 3 zeigt außerdem beispielhaft die Befestigungsabschnitte 160, mit denen das Gehäuse 40 auf dem Leiterbahnträger 20 aufgeschraubt ist. Die Figur 3 zeigt zwei Befestigungsabschnitte 160, selbstverständlich ist die Anzahl der Befestigungsabschnitte 160 beliebig.

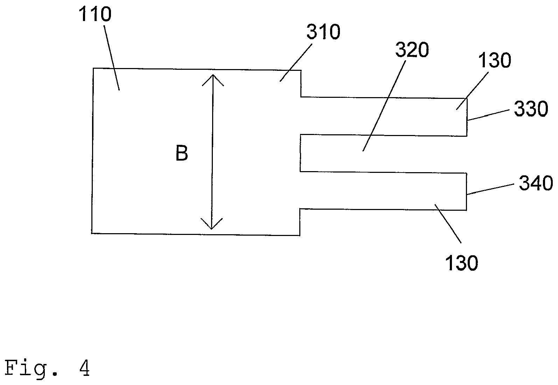

In der Figur 4 ist ein weiteres Ausführungsbeispiel für ein elektrisches Lötanschlusselement gezeigt. Im Unterschied zu den in der Figur 3 dargestellten Lötanschlusselementen ist das Lötanschlusselement 310 gemäß Figur 4 geschlitzt ausgeführt, so dass zwei durch einen Schlitz 320 getrennte, nebeneinanderliegende elektrische Einzelleiter 330 und 340 gebildet werden.

Der Vorteil geschlitzter Lötanschlusselemente besteht darin, dass diese mechanisch elastischer sind und somit nach einem Auflöten auf dem Leiterbahnträger 20 eine größere mechanische Flexibilität für die Verbindung zwischen dem Gehäuse 40 und dem Leiterbahnträger 20 als gleichbreite ungeschlitzte Lötanschlusselemente bereitstellen. Das elektrische Lötanschlusselement 310 ist somit mechanisch flexibler als dies der Fall wäre, wenn sich die Breite B des Lötanschlusselements 310 von dem einen Ende 110 durchgängig bis zu dem anderen Ende 130 erstrecken würde; darüber hinaus verbessert der Schlitz die thermischen Eigenschaften der Lötanschlusselemente und damit beispielsweise auch die Lotverteilung während der Lötung. Der elektrische Widerstand wird durch den Schlitz 320 je nach dessen Schlitzbreite nur unwesentlich erhöht, so dass der elektrische Gesamtwiderstand eines geschlitzten Lötanschlusselements zumindest näherungsweise dem elektrischen Widerstand eines ungeschlitzten Lötanschlusselements entsprechen kann.

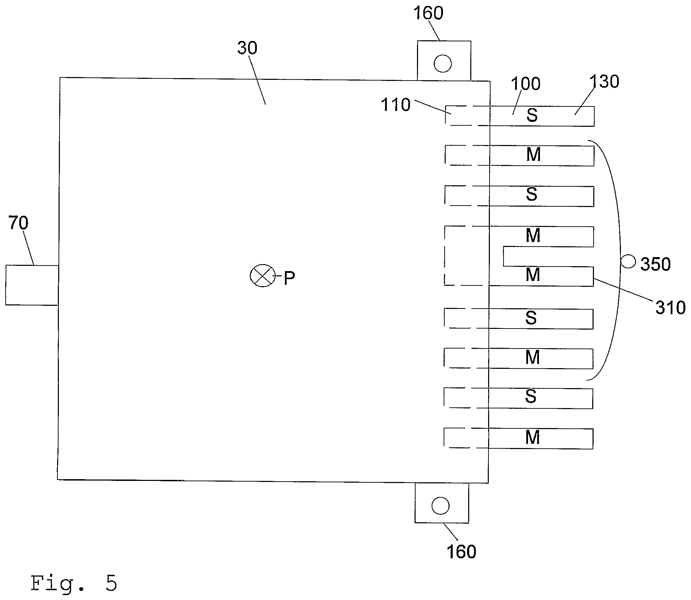

In der Figur 5 ist ein Ausführungsbeispiel für eine Anordnung 10 gezeigt, bei der ein geschlitztes Lötanschlusselement 310 eingesetzt wird. Das geschlitzte Lötanschlusselement 310 bildet mit benachbarten Lötanschlusselementen eine Lötanschlusselementgruppe 350, bei der das mittlere, geschlitzte Lötanschlusselement auf Masse geschaltet ist. Die Gruppe 350 bildet somit eine elektrische Beschaltungskonfiguration der Art Masse, Signal, Masse, Masse, Signal, Masse.

Bei den oben beschriebenen Ausführungsbeispielen wird es als vorteilhaft angesehen, wenn die Dicke der als Masseleiter beschalteten Lötanschlusselemente und die Dicke der als Signalleiter beschalteten Lötanschlusselemente gleich groß, zumindest im Wesentlichen gleich groß, sind. Auch wird es als vorteilhaft angesehen, wenn das Verhältnis zwischen der Breite eines ungeschlitzten Masseleiters und der Breite eines Signalleiters kleiner als oder gleich 2 ist. Auch sollte das Verhältnis zwischen der Breite eines Einzelmasseleiters eines geschlitzten Masseleiters - also eines mit Massepotential beaufschlagten geschlitzten Lötanschlusselements - und der Breite eines Signalleiters vorzugsweise kleiner als oder gleich 2 sein.

### Bezugszeichenliste

- 10: Anordnung
- 20: Leiterbahnträger
- 30: Bauelement
- 40: Gehäuse
- 50: Komponente
- 60: optische Schnittstelle
- 70: Lichtwellenleiter
- 80: elektrische Schnittstelle
- 90: Leiterbahn
- 100: Lötanschlusselement
- 110: ein Ende
- 120: Bodenanschlussabschnitt
- 125: Gehäuseboden
- 130: anderes Ende
- 140: Gehäusekontur
- 150: Bodenauflageabschnitt
- 160: Befestigungsabschnitt
- 170: Befestigungsloch
- 180: Befestigungsschraube
- 200: Spalt
- 210: Wellenwiderstandsanpassung
- 220: Beschichtung
- 230: Material
- 300: Gruppe
- 310: Lötanschlusselement
- 320: Schlitz
- 330: Einzelleiter
- 340: Einzelleiter
- 350: Gruppe

- A: Abstand
- B: Breite
- M: Masseleiter
- P: Pfeilrichtung
- S: Signalleiter

## Patentansprüche

1. Anordnung (10) mit einem elektrischen Leiterbahnträger (20) und einem auf dem Leiterbahnträger aufgebrachten Bauelement (30),
- wobei das Bauelement ein faseroptoelektronisches Bauelement ist und aufweist: ein Gehäuse (40), zumindest eine elektrooptische oder optoelektronische Komponente (50), mindestens eine mit der elektrooptischen oder optoelektronischen Komponente in Verbindung stehende faseroptische Schnittstelle (60) und mindestens eine elektrische Schnittstelle (80) zum Anschluss des Bauelements auf dem Leiterbahnträger, und
- wobei die elektrische Schnittstelle zumindest ein gebogenes elektrisches Lötanschlusselement (100) aufweist, das sich seitlich nach außen erstreckt und seitlich außerhalb der äußeren Gehäusekontur (140) auf dem Leiterbahnträger verlötet ist,
- wobei das zumindest eine gebogene elektrische Lötanschlusselement (100) mit seinem einen Ende (110) an einem Bodenanschlussabschnitt (120) des Gehäusebodens (125) des Gehäuses (40) angebracht ist und sich von dort seitlich derart nach außen erstreckt, dass das andere Ende (130) des Lötanschlusselements - in der Draufsicht - seitlich heraussteht und seitlich außerhalb der äußeren Gehäusekontur (140) auf dem Leiterbahnträger verlötet ist, und
- wobei das Lötanschlusselement derart vom Bodenanschlussabschnitt weggebogen ist, dass der Bodenanschlussabschnitt und damit der Gehäuseboden (125) einen mechanisches Spiel schaffenden Abstand (A) zu dem Leiterbahnträger aufweist,
**dadurch gekennzeichnet, dass**
- in zumindest einem Teilabschnitt des Spalts (200) zwischen dem Bodenanschlussabschnitt und dem Leiterbahnträger eine Reflexionen reduzierende Wellenwiderstandsanpassung (210) vorhanden ist,
- der Gehäuseboden einen Bodenauflageabschnitt (150) aufweist, der auf dem Leiterbahnträger unmittelbar aufliegt, und
- das Gehäuse zumindest einen Befestigungsabschnitt (160) aufweist, der mit dem Leiterbahnträger verschraubt ist.

2. Anordnung nach Anspruch 1,
**dadurch gekennzeichnet, dass**
der Spalt zwischen dem Bodenanschlussabschnitt und dem Leiterbahnträger zumindest teilweise mit einem Material (220, 230) gefüllt ist, dessen relative Dielektrizitätszahl größer als 1 ist.

3. Anordnung nach einem der voranstehenden Ansprüche,
**dadurch gekennzeichnet, dass**
auf dem Leiterbahnträger in dem Bereich des Spalts eine Beschichtung (220) aufgebracht ist.

4. Anordnung nach Anspruch 3,
**dadurch gekennzeichnet, dass**
die Beschichtung aus einem anderen Material besteht als die Leiterbahnen (90) des Leiterbahnträgers.

5. Anordnung nach einem der voranstehenden Ansprüche,
**dadurch gekennzeichnet, dass**
- der Befestigungsabschnitt ein Befestigungsloch (170) aufweist, durch das sich eine Befestigungsschraube (180) erstreckt,
- wobei der Durchmesser des Befestigungslochs größer als der Durchmesser der Befestigungsschraube dimensioniert ist, so dass ein mechanische Spannungen abbauendes Spiel zwischen Befestigungsloch und Befestigungsschraube vorhanden ist.

6. Anordnung nach einem der voranstehenden Ansprüche,
**dadurch gekennzeichnet, dass**
die elektrische Schnittstelle mehrere gebogene elektrische Lötanschlusselemente umfasst, die eine oder mehrere koplanare elektrische Leitungen bilden.

7. Anordnung nach einem der voranstehenden Ansprüche,
**dadurch gekennzeichnet, dass**
zumindest ein gebogenes elektrisches Lötanschlusselement geschlitzt ist und mindestens zwei nebeneinanderliegende elektrische Einzelleiter (330, 340) bildet.

8. Anordnung nach einem der voranstehenden Ansprüche,
**dadurch gekennzeichnet, dass**
eine Gruppe (300, 350) von nebeneinanderliegenden gebogenen elektrischen Lötanschlusselementen elektrisch in der Reihenfolge Masse, Signal, Masse, Signal, Masse beschaltet ist.

9. Anordnung nach Anspruch 8,
**dadurch gekennzeichnet, dass**
das mittlere, auf Masse geschaltete Lötanschlusselement (310) der Gruppe (350) geschlitzt ist und jeweils zwei nebeneinanderliegende Einzelmasseleiter bildet, so dass sich an der Schnittstelle zum Leiterbahnträger die elektrische Beschaltungskonfiguration Masse, Signal, Masse, Masse, Signal, Masse ergibt.

10. Anordnung nach einem der voranstehenden Ansprüche,
**dadurch gekennzeichnet, dass**
- die Dicke der als Masseleiter beschalteten Lötanschlusselemente und die Dicke der als Signalleiter beschalteten Lötanschlusselemente gleich groß sind und/oder
- das Verhältnis zwischen der Breite eines ungeschlitzten Masseleiters und der Breite eines Signalleiters kleiner als oder gleich zwei ist und/oder
- das Verhältnis zwischen der Breite eines Einzelmasseleiters eines geschlitzten, auf Massepotential liegenden Lötanschlusselements und der Breite eines Signalleiters kleiner als oder gleich zwei ist.

11. Verfahren zum Herstellen einer Anordnung (10) mit einem elektrischen Leiterbahnträger (20) und einem Bauelement (30), wobei bei dem Verfahren das Bauelement auf dem Leiterbahnträger aufgelötet wird,
- wobei ein faseroptoelektronisches Bauelement (30), das ein Gehäuse (40), zumindest eine elektrooptische oder optoelektronische Komponente (50), mindestens eine mit der Komponente in Verbindung stehende faseroptische Schnittstelle (60) und mindestens eine elektrische Schnittstelle (80) zum Anschluss des Bauelements auf dem Leiterbahnträger aufweist, auf dem Leiterbahnträger aufgelötet wird,
- wobei zumindest ein gebogenes elektrisches Lötanschlusselement (100) mit seinem einen Ende (110) an einem Bodenanschlussabschnitt (120) des Gehäusebodens (125) des Gehäuses (40) angebracht wird und das andere Ende (130) des Lötanschlusselements seitlich außerhalb der äußeren Gehäusekontur (140) auf dem Leiterbahnträger verlötet wird,
- wobei zwischen dem Gehäuseboden (125) und dem Leiterbahnträger ein mechanisches Spiel schaffender Abstand (A) geschaffen wird,
**dadurch gekennzeichnet, dass**
- in zumindest einem Teilabschnitt des Spalts (200) zwischen dem Bodenanschlussabschnitt und dem Leiterbahnträger eine Reflexionen reduzierende Wellenwiderstandsanpassung (210) vorgenommen wird,
- der Gehäuseboden einen Bodenauflageabschnitt (150) aufweist, der auf dem Leiterbahnträger unmittelbar aufgelegt wird, und
- das Gehäuse zumindest einen Befestigungsabschnitt (160) aufweist, der mit dem Leiterbahnträger verschraubt wird.

## Claims

1. Arrangement (10) comprising an electrical conductor track carrier (20) and a device (30) applied on the conductor track carrier,
- wherein the device is a fibre-optoelectronic device and comprises: a housing (40), at least one electro-optical or optoelectronic component (50), at least one fibre-optic interface (60) connected to the electro-optical or optoelectronic component, and at least one electrical interface (80) for connecting the device on the conductor track carrier, and
- wherein the electrical interface comprises at least one bent electrical soldering connection element (100) which extends laterally outwards and is soldered on the conductor track carrier laterally outside the outer housing contour (140),
- wherein the at least one bent electrical soldering connection element (100) is fitted by one end (110) thereof to a base connection section (120) of the housing base (125) of the housing (40) and extends outwards from there laterally in such a way that the other end (130) of the soldering connection element - in plan view - protrudes laterally and is soldered on the conductor track carrier laterally outside the outer housing contour (140), and
- wherein the soldering connection element is bent away from the base connection section in such a way that the base connection section, and thus the housing base (125), is at a distance (A) from the conductor track carrier that creates mechanical play,
**characterized in that**
- a reflection-reducing characteristic impedance matching element (210) is present in at least one partial section of the gap (200) between the base connection section and the conductor track carrier,
- the housing base has a base bearing section (150), which bears directly on the conductor track carrier, and
- the housing has at least one securing section (160) which is screwed to the conductor track carrier.

2. Arrangement according to Claim 1,
**characterized in that**
the gap between the base connection section and the conductor track carrier is at least partly filled with a material (220, 230) having a relative permittivity of greater than 1.

3. Arrangement according to either of the preceding claims,
**characterized in that**
a coating (220) is applied on the conductor track carrier in the region of the gap.

4. Arrangement according to Claim 3,
**characterized in that**
the coating consists of a different material from that of the conductor tracks (90) of the conductor track carrier.

5. Arrangement according to any of the preceding claims,
**characterized in that**
- the securing section has a securing hole (170), through which a securing screw (180) extends,
- wherein the diameter of the securing hole is dimensioned to be greater than the diameter of the securing screw, with the result that a play that reduces mechanical stresses is present between securing hole and securing screw.

6. Arrangement according to any of the preceding claims,
**characterized in that**
the electrical interface comprises a plurality of bent electrical soldering connection elements, which form one or a plurality of coplanar electrical lines.

7. Arrangement according to any of the preceding claims,
**characterized in that**
at least one bent electrical soldering connection element is slotted and forms at least two mutually adjacent electrical individual conductors (330, 340).

8. Arrangement according to any of the preceding claims,
**characterized in that**
a group (300, 350) of mutually adjacent bent electrical soldering connection elements is electrically connected up in the order ground, signal, ground, signal, ground.

9. Arrangement according to Claim 8,
**characterized in that**
the central, grounded soldering connection element (310) of the group (350) is slotted and forms in each case two mutually adjacent individual ground conductors, such that the electrical connection configuration ground, signal, ground, ground, signal, ground arises at the interface with the conductor track carrier.

10. Arrangement according to any of the preceding claims,
**characterized in that**
- the thickness of the soldering connection elements connected up as ground conductors and the thickness of the soldering connection elements connected up as signal conductors are equal in magnitude and/or
- the ratio between the width of an unslotted ground conductor and the width of a signal conductor is less than or equal to two and/or
- the ratio between the width of an individual ground conductor of a slotted soldering connection element that is at ground potential and the width of a signal conductor is less than or equal to two.

11. Method for producing an arrangement (10) comprising an electrical conductor track carrier (20) and a device (30), wherein in the method the device is soldered on the conductor track carrier,
- wherein a fibre-optoelectronic device (30) comprising a housing (40), at least one electro-optical or optoelectronic component (50), at least one fibre-optic interface (60) connected to the component, and at least one electrical interface (80) for connecting the device on the conductor track carrier is soldered on the conductor track carrier,
- wherein at least one bent electrical soldering connection element (100) is fitted by one end (110) thereof to a base connection section (120) of the housing base (125) of the housing (40) and the other end (130) of the soldering connection element is soldered on the conductor track carrier laterally outside the outer housing contour (140),
- wherein a distance (A) that creates mechanical play is created between the housing base (125) and the conductor track carrier,
**characterized in that**
- a reflection-reducing characteristic impedance matching (210) is performed in at least one partial section of the gap (200) between the base connection section and the conductor track carrier,
- the housing base has a base bearing section (150), which is placed directly on the conductor track carrier, and
- the housing has at least one securing section (160) which is screwed to the conductor track carrier.

## Revendications

1. Arrangement (10) comprenant un porte-piste conductrice (20) électrique et un élément structural (30) appliqué sur le porte-piste conductrice,
- l'élément structural étant un élément structural optoélectronique à fibre et possédant : un boîtier (40), au moins un composant électro-optique ou optoélectronique (50), au moins une interface pour fibre optique (60) qui se trouve en liaison avec le composant électro-optique ou optoélectronique et au moins une interface électrique (80) servant au raccordement de l'élément structural au porte-piste conductrice, et
- l'interface électrique possédant au moins un élément de raccordement par brasage (100) électrique coudé qui s'étend latéralement vers l'extérieur et qui est attaché par brasage sur le porte-piste conductrice latéralement en-dehors du contour de boîtier extérieur (140),
- l'au moins un élément de raccordement par brasage (100) électrique coudé étant monté par l'une de ses extrémités (110) au niveau d'une portion de raccordement de fond (120) du fond de boîtier (125) du boîtier (40) et s'étendant depuis cet endroit latéralement vers l'extérieur de telle sorte que l'autre extrémité (130) de l'élément de raccordement par brasage - vue de dessus - fait saillie latéralement et est attachée par brasage sur le porte-piste conductrice latéralement en-dehors du contour de boîtier extérieur (140), et
- l'élément de raccordement par brasage est coudé à l'écart de la portion de raccordement de fond de telle sorte que la portion de raccordement de fond et ainsi le fond de boîtier (125) présentent un écart (A) réalisant un jeu mécanique par rapport au porte-piste conductrice,
**caractérisé en ce que**
- une adaptation d'impédance caractéristique (210) réduisant les réflexions est présente dans au moins une portion partielle de l'intervalle (200) entre la portion de raccordement de fond et le porte-piste conductrice,
- le fond de boîtier possède une portion d'appui de fond (150) qui repose directement sur le porte-piste conductrice, et
- le boîtier possède au moins une portion de fixation (160) qui est attachée par vissage au porte-piste conductrice.

2. Arrangement selon la revendication 1, **caractérisé en ce que** l'intervalle entre la portion de raccordement de fond et le porte-piste conductrice est au moins partiellement rempli d'un matériau (220, 230) dont la constante diélectrique relative est supérieure à 1.

3. Arrangement selon l'une des revendications précédentes, **caractérisé en ce qu'**un revêtement (220) est appliqué sur le porte-piste conductrice dans la zone de l'intervalle.

4. Arrangement selon la revendication 3, **caractérisé en ce que** le revêtement se compose d'un autre matériau que celui des pistes conductrices (90) du porte-piste conductrice.

5. Arrangement selon l'une des revendications précédentes, **caractérisé en ce que**
- la portion de fixation possède un trou de fixation (170) à travers lequel s'étend une vis de fixation (180),
- le diamètre du trou de fixation étant d'une dimension supérieure à celle du diamètre de la vis de fixation, de sorte qu'il existe entre le trou de fixation et la vis de fixation un jeu qui soulage les contraintes mécaniques.

6. Arrangement selon l'une des revendications précédentes, **caractérisé en ce que** l'interface électrique comporte plusieurs éléments de raccordement par brasage électriques coudés qui forment une ou plusieurs lignes électriques coplanaires.

7. Arrangement selon l'une des revendications précédentes, **caractérisé en ce qu'**au moins un élément de raccordement par brasage électrique coudé est fendu et forme au moins deux conducteurs individuels (330, 340) électriques juxtaposés.

8. Arrangement selon l'une des revendications précédentes, **caractérisé en ce qu'**un groupe (300, 350) d'éléments de raccordement par brasage électriques coudés juxtaposés est connecté dans l'ordre masse, signal, masse, signal, masse.

9. Arrangement selon la revendication 8, **caractérisé en ce que** l'élément de raccordement par brasage central (310), connecté à la masse, du groupe (350) est fendu et forme respectivement deux conducteurs de masse individuels juxtaposés, de manière à obtenir la configuration de connexion électrique masse, signal, masse, masse, signal, masse au niveau de l'interface vers le porte-piste conductrice.

10. Arrangement selon l'une des revendications précédentes, **caractérisé en ce que**
- l'épaisseur des éléments de raccordement par brasage connectés en tant que conducteurs de masse et l'épaisseur des éléments de raccordement par brasage connectés en tant que conducteurs de signal sont de même valeur et/ou
- le rapport entre la largeur d'un conducteur de masse non fendu et la largeur d'un conducteur de signal est inférieur ou égal à deux et/ou
- le rapport entre la largeur d'un conducteur de masse individuel d'un élément de raccordement par brasage fendu se trouvant au potentiel de masse et la largeur d'un conducteur de signal est inférieur ou égal à deux.

11. Procédé de fabrication d'un arrangement (10) comprenant un porte-piste conductrice (20) électrique et un élément structural (30), l'élément structural étant brasé sur le porte-piste conductrice lors du procédé,
- un élément structural optoélectronique à fibre (30), lequel possède un boîtier (40), au moins un composant électro-optique ou optoélectronique (50), au moins une interface pour fibre optique (60) qui se trouve en liaison avec le composant et au moins une interface électrique (80) servant au raccordement de l'élément structural au porte-piste conductrice, étant brasé sur le porte-piste conductrice,
- au moins un élément de raccordement par brasage (100) électrique coudé étant monté par l'une de ses extrémités (110) au niveau d'une portion de raccordement de fond (120) du fond de boîtier (125) du boîtier (40) et l'autre extrémité (130) de l'élément de raccordement par brasage étant attachée par brasage sur le porte-piste conductrice latéralement en-dehors du contour de boîtier extérieur (140),
- un écart (A) réalisant un jeu mécanique étant réalisé entre le fond de boîtier (125) et le porte-piste conductrice,
**caractérisé en ce que**
- une adaptation d'impédance caractéristique (210) réduisant les réflexions est effectuée dans au moins une portion partielle de l'intervalle (200) entre la portion de raccordement de fond et le porte-piste conductrice,
- le fond de boîtier possède une portion d'appui de fond (150) qui est déposée directement sur le porte-piste conductrice, et
- le boîtier possède au moins une portion de fixation (160) qui est attachée par vissage au porte-piste conductrice.
